# EUROPEAN PATENT APPLICATION

(11) **EP 4 716 386 A1**
(43) Date of publication of application: **25.03.2026**
(21) Application number: 24201439.7
(22) Date of filing: 19.09.2024
(51) Int. Cl.: H05K 3/40, H05K 3/46, H05K 1/11, H05K 1/02

(54) **METHOD FOR MANUFACTURING THREE-DIMENSIONAL ELECTRICALLY CONDUCTIVE STRUCTURE**

(71) Applicant: Nederlandse Organisatie voor toegepast- natuurwetenschappelijk onderzoek TNO, 2595 DA 's-Gravenhage (NL)
(72) Inventor: VERDUCI, Tindara, 2595 DA' s-Gravenhage (NL); PETERS, Laurens Christiaan Johannes Maria, 2595 DA' s-Gravenhage (NL); CHIAPPINI, Francesca, 2595 DA' s-Gravenhage (NL)
(74) Representative: V.O.

(57) **Abstract**

A method for manufacturing a three-dimensional electrically conductive structure (100). A substrate (S) is provided with a structure (10) comprising a set of core structures (10p), each respective core structure (10p) extending with a respective height (H) above a surface of the substrate (S). A conductive seed layer (11) is applied to the substrate (S). A mask layer (12) is applied by coating to the conductive seed layer (11). The mask material (12m) forms a mask pattern masking the conductive seed layer (11) at respective masked areas (12p) of the substrate (S). The conductive seed layer (11) is exposed at respective exposed areas (12e, 12e'). Additional electrically conductive material (13m) is grown on the conductive seed layer (11) at the respective exposed areas (12e,12e'), including the conductive seed layer (11) covering the set of core structures (10p) to form part of the three-dimensional electrically conductive structure (100).

## Description

### TECHNICAL FIELD AND BACKGROUND

The present disclosure relates to a method of manufacturing a three-dimensional electrically conductive structure and products resulting from such method.

As background, Jungkwun Kim et al. [J. Micromech. Microeng. 23 (2013) 035006 (7pp); doi: 10.1088/0960-1317/23/3/035006] describes microfabrication of air core power inductors with metal-encapsulated polymer vias. The prior art introduces a solventless, thick sacrificial layer process using non-photopatternable SU-8 pellets as a key enabling step of the fabrication. In particular, the prior art uses EPON SU-8 as a sacrificial layer, and considers this attractive since not only can it be planarized at relatively low temperature, but also the lack of solvent precludes the need for extensive baking times. In the fabrication of bottom and vertical metal windings, according to the prior art, a seed layer is deposited, and the metalized structure is spray-coated using negative photoresist and baked. The photoresist-coated structure is patterned using proximity UV lithography to form a mold for the bottom windings and also to expose the vertical windings. The photoresist is exposed with UV, followed by a postexposure bake. The sample is developed and rinsed. After an oxygen plasma descum, electrodeposition is performed to form the bottom and vertical inductor windings simultaneously. The photoresist mold layers are removed and the underlying seed layers are etched, completing the bottom and vertical windings.

It is desired to alleviated disadvantages of the prior art while maintaining at least some of the advantages.

### SUMMARY

Aspects of the present disclosure relate to a method for manufacturing a three-dimensional electrically conductive structure. A substrate is provided with a structure comprising a set of core structures, each respective core structure extending with a respective height above a surface of the substrate surrounding the respective core structure. A conductive seed layer formed of an electrically conductive material is applied to the substrate. The conductive seed layer covers each of the set of core structures and respective areas of the substrate between the core structures. A mask layer formed of an electrically insulating mask material is applied to the conductive seed layer. The mask material forms a mask pattern masking the conductive seed layer at respective masked areas of the substrate. The conductive seed layer is exposed at respective exposed areas comprising the set of core structures. In other words, the core structures covered by the conductive seed layer are at least partially free of the mask material, preferably having an exposed seed layer along a height of the respective core structure. Alternatively, or in addition, the top surface of the respective core structure is free of the mask material. Additional electrically conductive material may be grown on the conductive seed layer at the exposed areas, including the conductive seed layer covering the set of core structures to form part of the three-dimensional electrically conductive structure. At the same time, growing of the additional electrically conductive material is substantially inhibited at the masked areas of the mask pattern. In other words, the growing of additional electrically conductive material is inhibited at the respective masked areas of the substrate surface around, in between and/or on top of the respective core structure.

As described herein, the mask layer is advantageously applied onto the seed layer by coating, e.g. spin coating, slit coating,. Preferably, a liquid precursor of the mask material is spread over the respective areas of the substrate in between the core structures. The inventors find that various parameters of the coating process combined with surface pre-treatment can be controlled for optimizing the deposition of the mask material, in particular for evenly spreading the mask material over the respective areas of the substrate in between the core structures. For example, the material properties of the mask material, the surface properties of the substrate surface, e.g. conductive seed layer, and/or other processing conditions (e.g. temperature) can be controlled and/or optimized for spreading the mask material. The surface pre-treatment can comprise treating the surface of the seed layer with a specific solvent and/or plasma. Also the layout of the structure, and in particular the set of core structures, can be optimized as described herein.

By applying the mask material and/or liquid precursor of the mask material, a thin and uniform mask layer can be applied in one processing step over the respective areas of the substrate in between core structures having a relatively high aspect ratio. Preferably, the mask material and/or liquid precursor is applied by spin coating. Also other ways of applying the mask material may be envisaged such as slot-die coating, blade coating, et cetera. By dissolving the mask material and/or liquid precursor of the mask material in a solvent having a relatively high boiling point with respect to the surrounding temperature, low viscosity of the mask material and/or the liquid precursor can be maintained for coating of the mask material over the respective areas of the substrate in between the core structures having a relatively high density. By evaporating the solvent from the mask material and/or the liquid precursor, the mask material can be solidified in one processing step to form an uniform and homogenous mask layer after the coating.

Even though coating of the mask material and/or spin coating of the liquid precursor may result in air bubbles trapped in corners of the structure and/or non-uniform mask material deposition at sharp corners, the inventors have realized that by using a negative photoresist as the mask material, areas of the mask layer exposed to an external trigger, e.g. light, become insoluble in a developer solution, while the unexposed areas remain soluble in the developer solution. Advantageously, the areas around the core structures, e.g. corners, which may contain trapped air bubbles and/or portions of a thick or non-uniform mask material are etched away in the developer solution, while the uniform portions of the mask material remain masking the conductive seed layer at the respective masked areas.

By patterning the mask layer, the set of core structures can be exposed for electroplating while leaving the surrounding area covered, thereby forming a mold for electroplating, e.g. by growing additional electrically conductive material on the respective exposed areas of the conductive seed layer. Advantageously, by using light to pattern the mask layer comprising the negative photoresist, the areas around the set of core structures, e.g. corners, which may contain trapped air bubbles and/or portions of a thick or non-uniform mask material receive less of the light, e.g. due to a shadow of the core structure, and are therefore more susceptible to etching as compared to areas located centrally between the core structures which receive more of the light. Advantageously, by controlling the properties of the solvent contained in the photoresist and/or used to pre-treat the surface of the conductive seed layer, the masked and exposed areas provided by patterning the mask material can be precisely controlled.

Advantageously, by comprising one or more pillars in the set of core structures, electrical interconnects to different circuit layers can be formed in a multilayer three-dimensional electrically conductive structure. For example, a first pillar having a first height can be configured to form a first electrical interconnect between a first electrical circuit layer and a second circuit layer, and a second pillar having a second height, distinct from the first height, can be configured to form a second electrical interconnect between the first electrical circuit layer and a third electrical circuit layer.

Advantageously, by including, in the mask pattern, respective masked areas along a height of the pillars and/or walls multiple electrical lanes along a height of the pillar and/or wall between different circuit layers of the three-dimensional electrically conductive structure.

Advantageously, the set of core structures can be immediately electrically connected, e.g. via a circuit lane in plane of the substrate, by simultaneously growing, e.g. in-plane or out-of-plane of the substrate and along two or three dimensions of the core structures, the additional electrically conductive material on the conductive seed layer covering the substrate surface and the set of core structures. By embedding the set of core structures covered by the additional electrically conductive material in a separation layer formed of an electrically insulating material a circuit layer can be applied on the separation layer for electrically connecting the respective core structure to a circuit lane, a bond pad, and/or another core structure of the set of core structures. By growing the additional electrically conductive material at an outer rim formed at a base of at least one core structure of the set of core structures, an electrical interconnect can be formed through the separation layer to the at least one core structure.

### BRIEF DESCRIPTION OF DRAWINGS

These and other features, aspects, and advantages of the apparatus, systems and methods of the present disclosure will become better understood from the following description, appended claims, and accompanying drawing wherein:
FIGs 1A-1F illustrate a method of manufacturing a three-dimensional electrically conductive structure;
FIGs 2A-2C illustrate a method of manufacturing a three-dimensional electrically conductive structure comprising a circuit lane electrically connecting to a core structure;
FIGs 3A-3C illustrate pre-treating a conductive seed layer with a solvent;
FIGs 4A-4E illustrate embedding a structure in a separation layer for applying a circuit layer;
FIGs 5A-5B illustrate a three-dimensional electrically conductive structure;
FIGs 6A-6C show manufacturing of a three-dimensional electrically conductive structure comprising pillars;
FIGs 7A-7C show manufacturing of a three-dimensional electrically conductive structure comprising a coaxial core structure;
FIGs 8A-8B show manufacturing of a three-dimensional electrically conductive structure comprising a coaxial core structure with electrical lanes.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

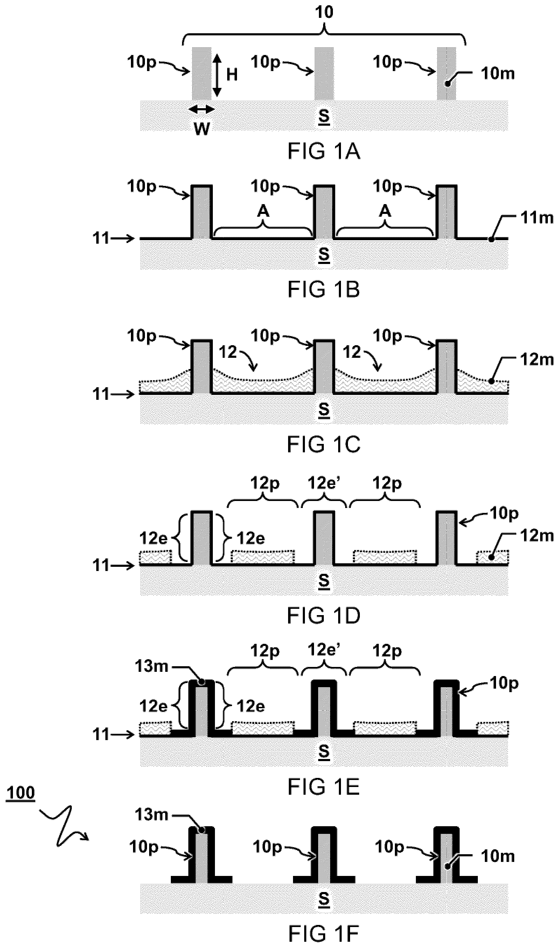

FIGs 1A-1F illustrate a method for manufacturing a three-dimensional electrically conductive structure 100. FIG 1A illustrates providing a substrate S with a structure 10 comprising a set of core structures 10p formed of a dielectric or conductive material 10m. Preferably, the substrate S is a holding substrate configured to hold the structure 10. Alternatively, or in addition, the substrate S is formed by a portion of electronics. In one embodiment, the structure 10 is formed of a polymer material. In another or further embodiment, the structure 10 is formed of SU-8, KMPR, HARE SQ or other kind of a dry film photoresist material. In yet another or further embodiment, the structure 10 is formed of other material, e.g. metal material distinct from the additional electrically conductive material (13m) and/or the conductive seed layer (11) material. By using a photolithography process to form the structure 10, set of core structures 10p of different shape and various width (W) to height (H) aspect ratios can be provided on the substrate S, e.g. 1:5, 1:10, 1:20. For example, the width (W) may refer to the diameter of a respective pillar structure and/or (minimum) width (W) of a respective wall structure.

FIG 1B illustrates applying a conductive seed layer 11 formed of an electrically conductive material 11m to the substrate S. The conductive seed layer 11 covers at least partially each of the set of core structures 10p and respective areas A of the substrate S between the core structures. In one embodiment, the conductive seed layer 11 is formed of an electrically conducting material having thickness between one nanometer up to a thousand nanometers. In another or further embodiment, the conductive seed layer 11 is applied using sputtering, atomic layer deposition, and/or Plasma-Enhanced Chemical Vapor Deposition or printing processes. In some embodiments, the conductive seed layer (11) comprises Titanium and/or Copper and/or Tungsten and/or Gold and/or Silver and/or Nikel.

FIGs 1C-1D illustrate applying a mask layer 12 formed of an electrically insulating mask material 12m to the conductive seed layer 11. In one embodiment, e.g. as shown in FIG 1D, the mask material 12m forms a mask pattern masking the conductive seed layer 11 at respective masked areas 12p of the substrate S surface around and/or in between the core structures 10p. Alternatively, or in addition, the mask pattern covers at least partially the respective core structure 10p, e.g. its top or side. In another or further embodiment, the conductive seed layer 11 is exposed at respective exposed areas 12e comprising the set of core structures 10p. In some embodiments, the thickness of the mask layer 12 and/or the height of a liquid precursor 12m' of the mask layer 12 is between one tenth to one thousand micrometers, preferably in a range from one to ten micrometers, even more preferably smaller than the height of the set of core structures 10p on the substrate S.

FIGs 1E-1F illustrate growing additional electrically conductive material 13m on the conductive seed layer 11 at the exposed areas 12e, including the conductive seed layer 11 covering the set of core structures 10p to form part of the three-dimensional electrically conductive structure 100. In some embodiments, growth of the additional electrically conductive material 13m at the masked areas 12p of the mask pattern is substantially inhibited. In other or further embodiments, growing the additional electrically conductive material 13m comprises electroplating the conductive seed layer 11 which acts as an electrode.

In some embodiments, the mask layer 12 is applied onto the seed layer by coating a liquid precursor 12m' of the mask material 12m over the respective areas A of the substrate S between the core structures of set of core structures 10p. In one embodiment, the liquid precursor 12m' comprises the mask material 12m dissolved in a solvent having a relatively high boiling point, e.g. 140°C, 160°C, 180°C, more than 200°C, up to 300°C or more. In another or further embodiment, the mask material 12m comprises a negative photoresist for patterning the mask material 12m to form the mask pattern masking the conductive seed layer 11 at the respective masked areas 12p of the substrate S surface around and/or in between the core structures 10p. In some embodiments, the mask layer 12 a negative photoresist suitable for microfabrication.

In some embodiments, applying the mask layer 12 comprises evaporating the solvent 12m from the liquid precursor 12m' to form the mask material 12m on the conductive seed layer 11. Preferably, evaporation of the solvent is promoted by a rapid spinning during coating of the liquid precursor 12m'. Alternatively, or in addition, the evaporation of the solvent is promoted by baking, air drying, inert gas flow, infrared or microwave drying.

In other or further embodiments, e.g. as shown in FIG 1D, the mask material 12m is patterned by light to form a mask pattern masking the conductive seed layer 11 at the respective masked areas 12p and to expose the conductive seed layer 11 at the respective exposed areas 12e. In one embodiment, the light comprises electromagnetic radiation, ultraviolet light, visible light, and/or infrared light. In another or further embodiment, the mask material 12m is patterned by light radiated through a mask corresponding to the mask pattern. Alternatively, or in addition, a beam of light radiation is directed or steered to the mask material 12m for forming the mask pattern.

In yet other or further embodiments, the mask material 12m is subsequently stripped in a developer solution to form the respective masked areas 12p of the substrate S surface and exposed areas 12e comprising the set of core structures 10p. Preferably, the conductive seed layer 11 covering the respective core structure is fully exposed, e.g. along the entire length of the respective core structure, after the patterning and subsequent etching of the mask material 12m. For example, the top and/or sides of the core structures are free of the mask material 12m. In some embodiments, also an area of the conductive seed layer 11 on the substrate S directly adjacent and/or surrounding one or more of the core structures may be exposed and/or free of the mask material for electroplating and/or forming part of the three-dimensional electrically conductive structure 100. Alternatively, or in addition, only the conductive seed layer 11 on the core structure itself, or at least top section (e.g. top half) of a respective core structure may be exposed or free of the mask material 12m, e.g. as shown in FIG 1C.

In some embodiments, e.g. as shown in FIGs 1E-1F, the mask layer 12 is removed by stripping the mask material 12m from the conductive seed layer 11 after growing the additional electrically conductive material 13m. In one embodiment, stripping the mask material 12m comprises immersing the mask layer 12 in a solvent. In another or further embodiment, e.g. as shown in FIG 1F, at least part of the conductive seed layer 11 is removed, after stripping the mask material 12m, by etching the electrically conductive material 11m to disconnect electrical connection between respective core structure of the set of core structures 10p. Preferably, the electrically conductive material 11m is etched in a solution of water and hydrofluoric or hydrochloric acid.

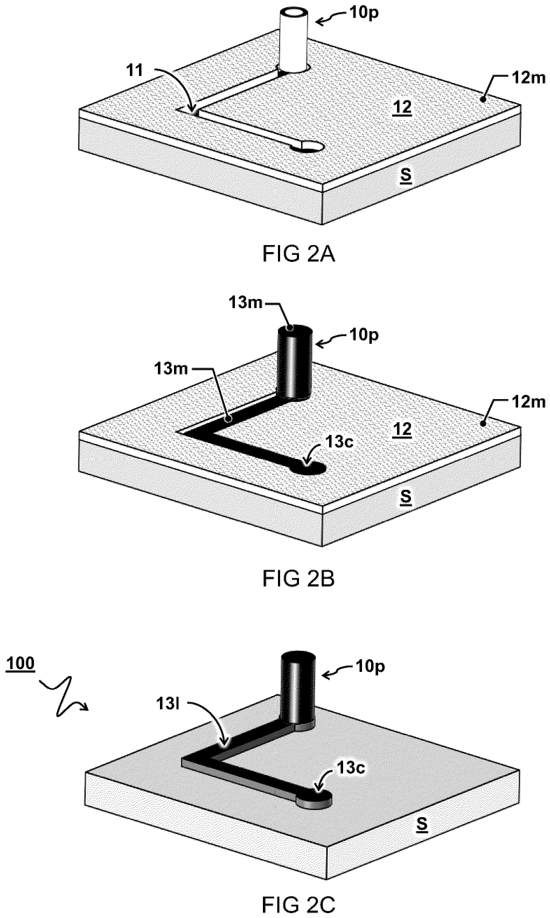

FIGs 2A-2C illustrate a method of manufacturing a three-dimensional electrically conductive structure comprising a circuit lane electrically connecting to a core structure. In some embodiments, additional electrically conductive material 13m is grown on the conductive seed layer 11 to form at least one circuit lane 131 in plane of the substrate S. In one embodiment, the at least one circuit lane 131 is electrically connected to the additional electrically conductive material 13m grown simultaneously with the circuit lane 131 on at least one of the set of core structures 10p.

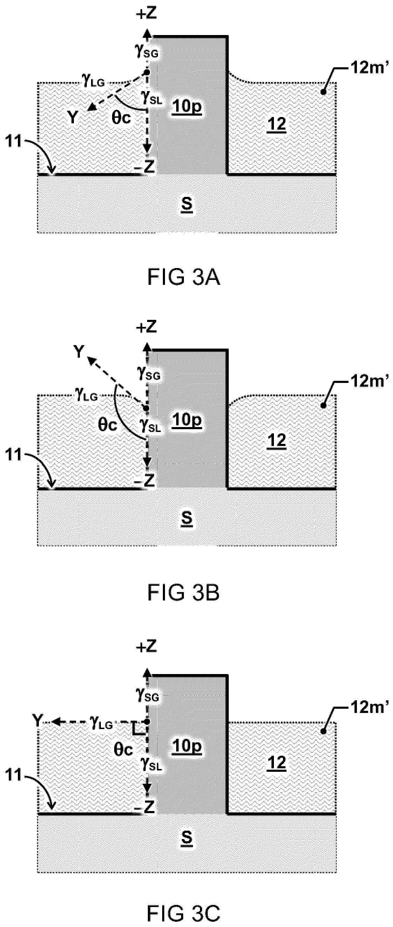

FIGs 3A-3C illustrate pre-treating a conductive seed layer 11 with a solvent prior to applying the mask layer 12 formed of the mask material 12m comprising the solvent. In some embodiments, properties of the solvent are selected and/or controlled for tuning the uniformity and/or homogeneity of the liquid precursor 12m' forming the mask material 12m on the conductive seed layer 11. In one embodiment, pre-treating the seed layer with the solvent comprises prewetting and/or tuning the surface chemistry, e.g. surface tension. In another or further embodiment, tuning the uniformity and/or homogeneity of the liquid precursor 12m' comprises tuning the contact angle θc. In one embodiment, the contact angle θc is formed at the junction where the liquid interface of the liquid precursor 12m' meets the solid surface of the set of core structures 10p covered by the conductive seed layer 11.

In some embodiments, a smaller contact angle θc, e.g. less than ninety degrees as shown in FIG 3A, indicates that the liquid precursor 12m' wets the conductive seed layer 11 well, thereby spreading well over the surface of the set of core structures 10p. In other or further embodiments, a larger contact angle θc, e.g. greater than ninety degrees as shown in FIG 3B, indicates that the liquid precursor 12m' wets the conductive seed layer 11 poorly, thereby repelling from the surface of the set of core structures 10p. In yet further embodiments, the contact angle θc is equal, or close to, ninety degrees, e.g. as shown in FIG 3C, indicating that the surface of the mask layer 12 formed by the liquid precursor 12m' is perpendicular to the set of core structures 10p. Preferably, the contact angle θc is small in case of a negative photoresist, because the portion of the mask material 12m that is spreading well over the surface of the set of core structures 10p will be subsequently washed away in a developer solution. Even more preferably, the contact angle θc is equal, or close to, ninety degrees in case of either the negative or positive photoresist, thereby providing the most precise control of patterning and etching the mask material 12m. Alternatively, the contact angle θc is large in case of a positive photoresist to prevent residues of the mask layer 12 on the set of core structures 10p after patterning and subsequent etching of the mask material 12m.

Preferably, the conductive seed layer 11 is pre-treated with a surface treatment method prior to applying the mask layer 12 formed of the mask material 12m, e.g. using plasma or chemical treatment, or self assemble monolayer etch. In one embodiment, properties of the surface treatment method are selected and/or controlled for tuning the uniformity and/or homogeneity of the mask material 12m on the conductive seed layer 11.

In some embodiments, the structure 10 comprising the set of core structures 10p is configured to least partially facilitate spreading of the liquid precursor 12m' over the substrate S surface around and/or in between the core structures 10p during spin coating of the liquid precursor (12m') of the mask material (12m). In some embodiments, the structure 10 comprises a set of set of core structures 10p arranged in a plurality of concentric shapes. In one embodiment, the distance between the shape increases as a function of a radial direction of the largest shape within the plurality of concentric shapes, e.g. circles. In another or further embodiment, the structure 10 comprises intermediate channels for facilitating spreading of the liquid precursor 12m' between the set of core structures 10p during the spin coating, e.g. openings between a plurality of concentric shapes. In yet another or further embodiment, the structure 10 comprises a set of core structures 10p disposed at a distance smaller than two hundred micrometers, e.g. at a distance of ten micrometers, one hundred micrometers, up to two hundred micrometers or more.

In other or further embodiments, the structure 10 comprises lower density of the set of core structures 10p at the central portion of the structure 10 as compared to the outer portion of the structure 10. In one embodiment, the density of the set of core structures 10p is lower in the central portion of the structure 10 as compared to the outer portion of the structure 10 for facilitating uniform spin coating of the liquid precursor 12m' from the center of the structure 10 outwardly. For example, the density of the set of core structures 10p at the central portion of the structure 10 is a factor of five, twenty, up to forty or more higher as compared to the outer portion of the structure 10.

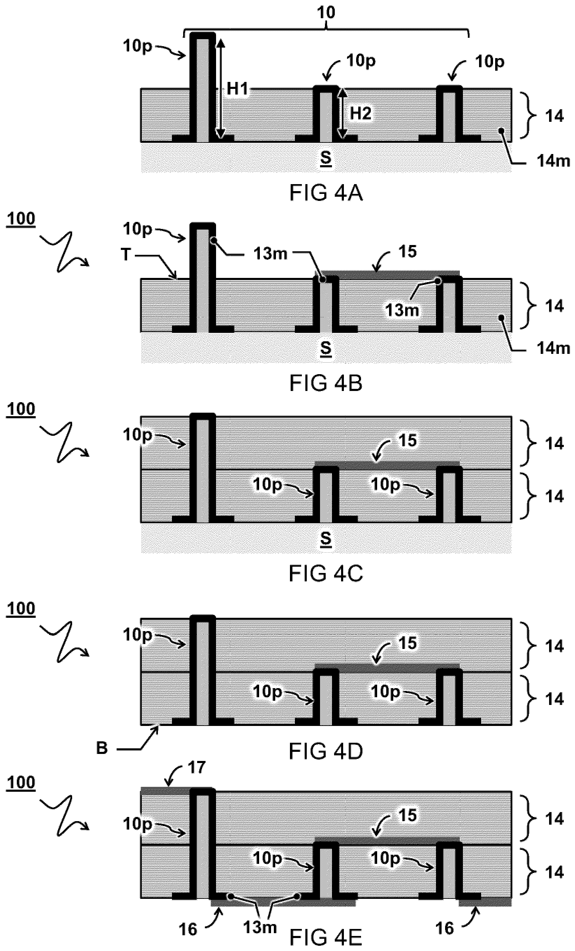

FIGs 4A-4E illustrate embedding of a structure in a separation layer for applying a circuit layer. In some embodiments, the additional electrically conductive material 13m grown on the structure 10 is embedded in a separation layer 14 formed of an electrically insulating material 14m for applying a first circuit layer 15 to a top side T of the separation layer 14 and electrically connecting to at least a part of the additional electrically conductive material 13m on at least one of the set of core structures 10p. In other or further embodiments, the structure (10) is embedded in a separation layer (14) formed of an electrically insulating material (14m) for removing the substrate S from the bottom side B of the separation layer 14 to at least partially expose the additional electrically conductive material 13m for applying a second circuit layer 16 on the bottom side B of the separation layer and/or electrically contacting the additional electrically conductive material 13m embedded in the separation layer 14. In one embodiment, the structure 10 comprises a set of core structures 10p of the same height (H), e.g. forming an electrical connection through a single layer in an electronic stack. In another or further embodiment, the structure 10 comprises a set of core structures 10p of different heights, e.g. forming electrical connections to different layers of a multilayer electronic stack. In yet another or further embodiment, e.g. as shown in FIG 4E, the set of core structures 10p comprises a first pillar having a first height H1, and a second pillar having a second height H2, distinct from the first height H1. The first pillar is configured to form a first electrical interconnect between a first electrical circuit layer 15 and a second circuit layer 16, and the second pillar is configured to form a second electrical interconnect between the first electrical circuit layer and a third electrical circuit layer 17. Preferably, each of the first, second, and third electrical circuit layers are distinct circuit layers in a multilayer three-dimensional electrically conductive structure 100.

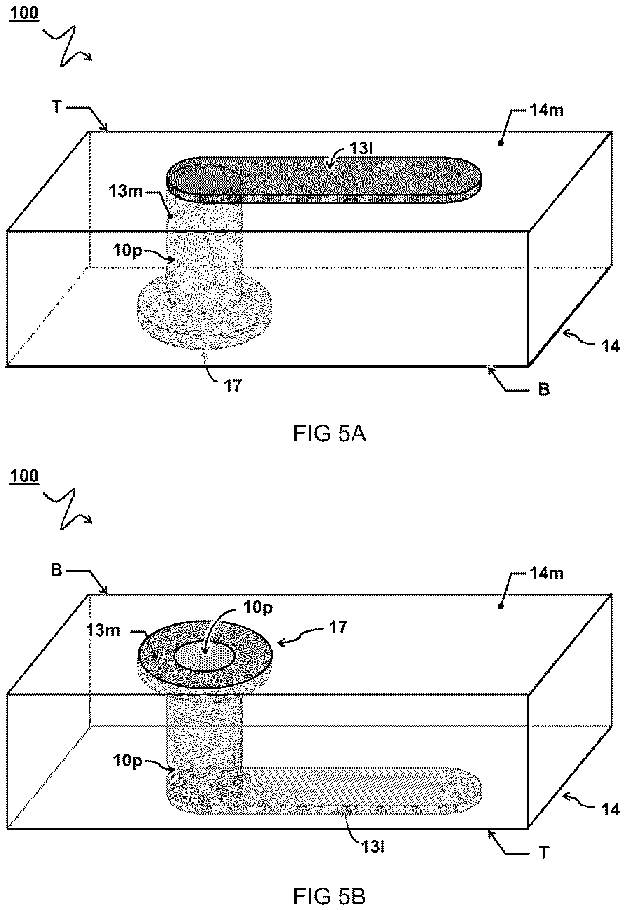

FIGs 5A-5B illustrate a three-dimensional electrically conductive structure 100. In one embodiment, the three-dimensional electrically conductive structure 100 is embedded in a separation layer 14 and comprises a set of core structures 10p. In another or further embodiment, the three-dimensional electrically conductive structure 100 comprises an outer rim 17 formed at a base of at least one core structure of the set of core structures 10p. In yet another or further embodiment, the three-dimensional electrically conductive structure 100 comprises an additional electrically conductive material 13m grown on the set of core structures 10p and the outer rim for electrically interconnecting the at least one core structure of the set of core structures 10p through the separation layer 14 to a circuit lane 131 and/or a circuit layer 15,16. In one embodiment, the three-dimensional electrically conductive structure 100 forms a part of a radiofrequency electronic device.

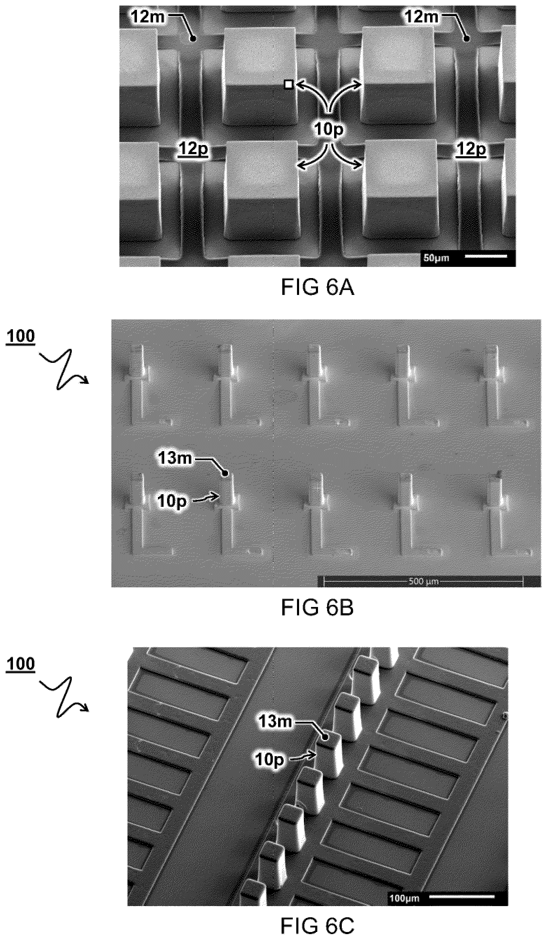

FIGs 6A-6C show manufacturing of a three-dimensional electrically conductive structure 100 comprising pillars. FIG 6A shows a Scanning Electron Microscope (SEM) image of a mold formed by patterning and etching the mask layer material 12m around the pillars 10p. FIG 6B shows an optical microscope image of three-dimensional through-package vias formed by respective pillars 10p electroplated by an additional electrically conductive material 13m. FIG 6C shows a SEM image of three-dimensional electrical connections formed by respective pillars 10p and electroplated by an additional electrically conductive material 13m.

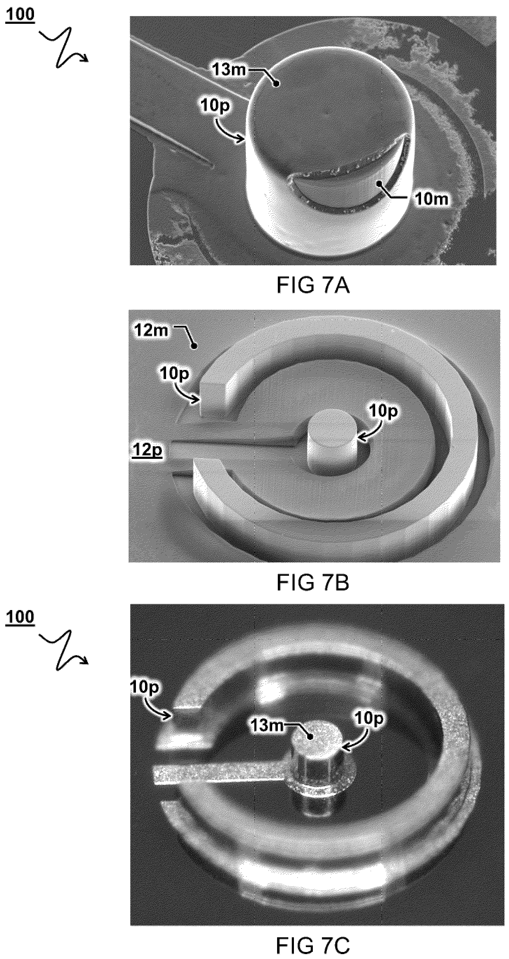

FIGs 7A-7C show manufacturing of a three-dimensional electrically conductive structure comprising a coaxial core structure. FIG 7A shows a SEM image of an eroded three-dimensional coaxial core structure formed by a pillar 10p electroplated with an additional electrically conductive material 13m. FIG 7B shows a SEM image of patterning the mask layer material 12m around the coaxial core structure formed by a pillar and a partially circular wall. FIG 7C shows an optical microscope image of a three-dimensional coaxial structure comprising the pillar and wall electroplated with an additional electrically conductive material 13m.

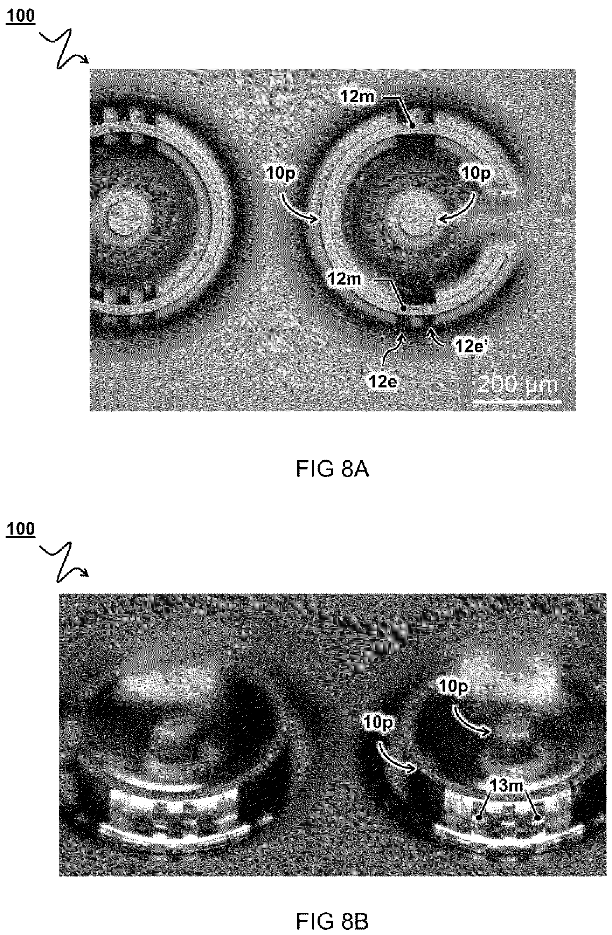

FIGs 8A-8B show manufacturing of a three-dimensional electrically conductive structure comprising a coaxial core structure with electrical lanes. FIG 8A shows an optical microscope image of a patterning of a mask material 12m on top and bottom side of the coaxial core structure 10p comprising a pillar and wall. FIG 8B shows an optical microscope image of the patterning of the mask material 12m on the side of the coaxial core structure 10p. In one embodiment, e.g. as shown in FIGs 8A-8B, the mask pattern includes respective masked areas 12p along a height H of the pillars and/or walls. In some embodiments, at least one pillar and/or wall comprises a first exposed area 12e separated by part of the mask pattern from a second exposed area 12e'. In other or further embodiments, the first exposed area 12e is configured to form a first electrical lane along a height H of the pillar and/or wall and the second exposed area 12e' is configured to form a second electrical lane along the height H of the pillar and/or wall. In yet other or further embodiments, the first and second electrical lanes form separate electrical interconnects between different circuit layers.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. A method for manufacturing a three-dimensional electrically conductive structure (100), the method comprising
providing a substrate (S) with a structure (10) comprising a set of core structures (10p), each respective core structure (10p) extending with a respective height (H) above a surface of the substrate (S) surrounding the respective core structure (10p);
applying a conductive seed layer (11) formed of an electrically conductive material (11m) to the substrate (S), the conductive seed layer (11) covering each of the set of core structures (10p) and respective areas (A) of the substrate (S) between the core structures;
applying a mask layer (12) formed of an electrically insulating mask material (12m) to the conductive seed layer (11), wherein the mask material (12m) forms a mask pattern masking the conductive seed layer (11) at respective masked areas (12p) of the substrate (S) wherein the conductive seed layer (11) is exposed at respective exposed areas (12e,12e') ;
growing additional electrically conductive material (13m) on the conductive seed layer (11) at the exposed areas (12e), including the conductive seed layer (11) covering the set of core structures (10p) to form part of the three-dimensional electrically conductive structure (100), wherein growing of the additional electrically conductive material (13m) is substantially inhibited at the masked areas (12p) of the mask pattern.

2. The method according to the preceding claim, wherein the mask layer (12) is applied onto the conductive seed layer (11) covering the substrate (S) by spin coating a liquid precursor (12m') of the mask material (12m) spreading over the respective areas (A) of the substrate (S) covered by the conductive seed layer (11) in between the core structures (10p)

3. The method according to the preceding claim, wherein the liquid precursor (12m') comprises the mask material (12m) dissolved in a solvent having a boiling point higher than 180°C for alleviating premature evaporation of the solvent during the spreading of the liquid precursor (12m') over the respective areas (A) of the substrate (S) in between the core structures (10p) during the spin coating.

4. The method according to the preceding claim, wherein the conductive seed layer (11) is pre-treated with the solvent, prior to applying the mask layer (12) formed of the mask material (12m) comprising the same solvent.

5. The method according to any of the preceding claims comprising pre-treating the conductive seed layer (11) with a surface treatment prior to applying the mask layer (12).

6. The method according to the two preceding claims, wherein the plasma treatment is applied prior to pre-treating the conductive seed layer (11) with the solvent.

7. The method according to any of the preceding claims, wherein the set of core structures (10p) comprises one or more pillars configured to form respective electrical interconnects and/or one or more walls configured to form respective electrical shielding structures.

8. The method according to the preceding claim, wherein the set of core structures (10p) comprises a first pillar having a first height (H1), and a second pillar having a second height (H2), distinct from the first height (H1); wherein the first pillar is configured to form a first electrical interconnect between a first electrical circuit layer (15) and a second circuit layer (16), and the second pillar is configured to form a second electrical interconnect between the first electrical circuit layer and a third electrical circuit layer (17), wherein each of the first, second, and third electrical circuit layers are distinct circuit layers in a multilayer three-dimensional electrically conductive structure (100).

9. The method according to claim 7 or any claim dependent thereon, wherein the mask pattern includes respective masked areas (12p) along a height (H) of the pillars and/or walls, wherein at least one pillar and/or wall comprises a first exposed area (12e) separated by part of the mask pattern from a second exposed area (12e'), wherein the first exposed area (12e) is configured to form a first electrical lane along a height (H) of the pillar and/or wall and the second exposed area (12e') is configured to form a second electrical lane along the height (H) of the pillar and/or wall, wherein the first and second electrical lanes form separate electrical interconnects between different circuit layers.

10. The method according to any of the preceding claims, wherein the mask material (12m) comprises a negative photoresist for patterning the mask material (12m) to form the mask pattern masking the conductive seed layer (11) at the respective masked areas (12p) of the substrate (S) surface around and/or in between the core structures (10p).

11. The method according to any of the preceding claims, wherein the mask layer (12) is removed by stripping the mask material (12m) from the conductive seed layer (11) after growing the additional electrically conductive material (13m); wherein at least part of the conductive seed layer (11) is removed, after stripping the mask material (12m), by etching the electrically conductive material (11m) to disconnect an electrical connection of the conductive seed layer (11) between the additionally grown electrically conductive material covering respective core structure of the set of core structures (10p).

12. The method according to any of the preceding claims, wherein respective properties of the liquid precursor (12m') are selected and/or controlled for spreading the mask material (12m) to form the mask layer (12) having a substantially uniform thickness covering the conductive seed layer (11) at the respective masked areas (12p) of the substrate (S), wherein the structure (10) is configured to at least partially facilitate spreading of the liquid precursor (12m') over the substrate (S) surface around and/or in between the core structures (10p) during coating of the liquid precursor (12m') of the mask material (12m).

13. The method according to any of the preceding claims, wherein the additional electrically conductive material (13m) grown on the conductive seed layer (11) covering the set of core structures (10p) simultaneously forms at least one circuit lane (131) in plane of the substrate (S), wherein the at least one circuit lane (131) is electrically connected to the additional electrically conductive material (13m) grown on at least one of the set of core structures (10p).

14. The method according to any of the preceding claims, wherein the additional electrically conductive material (13m) grown on the structure (10) is embedded in a separation layer (14) formed of an electrically insulating material (14m) for at least one of
applying a first circuit layer (15) to a top side (T) of the separation layer (14) and electrically connecting to at least a part of the additional electrically conductive material (13m) on at least one of the set of core structures (10p); and
removing the substrate (S) from the bottom side (B) of the separation layer (14) to at least partially expose the additional electrically conductive material (13m) for applying a second circuit layer (16) on the bottom side (B) of the separation layer and/or electrically contacting the additional electrically conductive material (13m) embedded in the separation layer (14).

15. A three-dimensional electrically conductive structure (100) manufactured according to the method of any of the preceding claims, wherein the three-dimensional electrically conductive structure (100) is embedded in a separation layer (14) and comprises
a set of core structures (10p);
an outer rim (17) formed at a base of at least one core structure of the set of core structures (10p); and
an additional electrically conductive material (13m) grown on the set of core structures (10p) and the outer rim (17) for electrically interconnecting the at least one core structure of the set of core structures (10p) through the separation layer (14) to a circuit lane (131) and/or a circuit layer (15,16).
